# EUROPÄISCHE PATENTSCHRIFT

(11) **EP 1 190 447 B1**
(45) Veröffentlichungstag und Bekanntmachung des Hinweises auf die Patenterteilung: **16.09.2009**
(21) Anmeldenummer: 00943662.7
(22) Anmeldetag: 30.05.2000
(51) Int. Cl.: H01L 29/78, H01L 29/36, H01L 29/10, H01L 29/423

(54) **TRENCH-MOS-TRANSISTOR**
TRENCH MOS-TRANSISTOR
TRANSISTOR MOS A TRANCHEE

(30) Priorität: 25.06.1999 DE 19929175
(43) Veröffentlichungstag der Anmeldung: 27.03.2002
(73) Patentinhaber: Infineon Technologies AG, 81669 München (DE)
(72) Erfinder: LARIK, Joost, D-85586 Poing (DE); HIRLER, Franz, D-84424 Isen (DE); KOTEK, Manfred, A-9500 Villach (AT); PFIRSCH, Frank, D-81545 München (DE)
(74) Vertreter: Kottmann, Heinz Dieter
(86) Internationale Anmeldenummer: PCT/DE2000/001772
(87) Internationale Veröffentlichungsnummer: WO 2001/001484

(56) Entgegenhaltungen:
- US-A- 4 914 058
- US-A- 4 941 026
- US-A- 5 072 266

## Beschreibung

Die vorliegende Erfindung betrifft einen Trench-MOS-Transistor mit einem Halbleiterkörper des einen Leitungstyps, in welchem ein mit einer Gate-Elektrode versehener Graben vorgesehen ist, der in einer Seitenfläche an seinem oberen Ende wenigstens eine Sourcezone des einen Leitungstyps aufweist und mit seinem unteren Ende in den wenigstens eine Drainzone des einen Leitungstyps bildenden Halbleiterkörper hineinreicht, wobei zwischen Sourcezone und Drainzone ein Bodybereich des anderen Leitungstyps und ein höher als der Bodybereich dotiertes Gebiet des anderen Leitungstyps vorgesehen sind und die Gateelektrode von Sourcezone, Bodybereich und Drainzone durch eine Isolierschicht getrennt ist, die eine Stufe aufweist, so daß die Isolierschicht zum unteren Ende des Grabens hin eine größere Schichtdicke als an dessen oberem Ende hat.

Ein solcher Trench-MOS-Transistor ist aus US-A-4 914 058 bekannt.

Bei der Entwicklung neuer Generationen von DMOS-Leistungstransistoren ist ein wichtiges Ziel die Verringerung des spezifischen Einschaltwiderstandes Rₒₙ.A (A = wirksame Fläche). Durch Erfüllung dieser Forderung kann einerseits die statische Verlustleistung in einem DMOS-Leistungstransistor minimiert werden; andererseits lassen sich dadurch im DMOS-Leistungstransistor höhere Stromdichten erreichen, wodurch kleinere und weniger aufwendige Chips für eine den gleichen Gesamtstrom verarbeitende Anordnung eingesetzt werden können.

Bekanntlich kann der spezifische Einschaltwiderstand Rₒₙ erheblich vermindert werden, wenn von der planaren Struktur abgegangen wird und eine Trench-Struktur zur Anwendung gelangt. Dies gilt insbesondere bei integrierten Anordnungen, bei welchen daher bevorzugt Trenchzellen anstelle planarer Strukturen eingesetzt werden. Durch den Einsatz von Trenchzellen kann insbesondere der Kanalwiderstand infolge einer erheblichen Vergrößerung der Kanalweite pro Fläche reduziert werden.

Der Widerstand der bevorzugt in einer epitaktischen Schicht auf einem Halbleitersubstrat liegenden Driftstrecke, der sogenannte "Epiwiderstand", kann durch Verwenden von tiefen Trenches reduziert werden (vgl. hierzu insbesondere US-A-4 941 026). Solche tiefen Trenches setzen aber in ihrem unteren Bereich eine dickere Isolierschicht als im eigentlichen Kanalbereich voraus. An dem Übergang zwischen der dickeren und der dünneren Isolierschicht, die bevorzugt aus Siliziumdioxid besteht, liegt eine Oxidstufe vor, die bei tiefen Trenches nicht zu vermeiden ist.

An dieser Oxidstufe treten aber im Sperrbetrieb des MOS-Transistors erhebliche Spitzen des elektrischen Feldes im Halbleiterkörper unmittelbar unterhalb der Stufe auf. Bei kleinem Abstand zwischen benachbarten Trenches sind diese Spitzen des elektrischen Feldes höher als die Werte des elektrischen Feldes in der Zellmitte am pn-Übergang zwischen Sourcezone und Bodybereich. Es können daher eine Lawinenmultiplikation von Ladungsträgern und eine Injektion von heißen Ladungsträgern in die Gate-Isolierschicht auftreten, wodurch diese geschädigt wird und gegebenenfalls sogar eine Zerstörung des MOS-Transistors hervorgerufen wird.

Bisher ist dieses Problem, das speziell bei MOS-Transistoren mit tiefen Trenches vorliegt, in seinen Konsequenzen noch nicht erkannt worden.

Es ist daher Aufgabe der vorliegenden Erfindung, einen Trench-MOS-Transistor mit tiefen Trench zu schaffen, bei dem ein Durchbruch an der Oxidstufe im Trench zuverlässig verhindert wird.

Diese Aufgabe wird bei einem Trench-MOS-Transistor mit einem Halbleiterkörper des einen Leitungstyps, in welchem ein mit einer Gate-Elektrode versehener Graben vorgesehen ist, der in einer Seitenfläche an seinem oberen Ende wenigstens eine Sourcezone des einen Leitungstyps aufweist und mit seinem unteren Ende in den wenigstens eine Drainzone des einen Leitungstyps bildenden Halbleiterkörper hineinreicht, wobei zwischen Sourcezone und Drainzone ein Bodybereich des anderen Leitungstyps und ein höher als der Bodybereich dotiertes Gebiet des anderen Leitungstyps vorgesehen sind und die Gate-Elektrode von Sourcezone, Bodybereich und Drainzone durch eine Isolierschicht getrennt ist, die eine Stufe aufweist, so daß die Isolierschicht zum unteren Ende des Grabens hin eine größere Schichtdicke als an dessen oberen Ende hat, erfindungsgemäß dadurch gelöst, daß der Bodybereich zur Drainzone hin zwischen dem Graben und einem benachbarstem, ebenso mit einer Gateelektrode verscehenen Graben des Trench-MOS-Transistors mit dem Gebiet des anderen Leitungstyps verstärkt ist, wobei dieses Gebiet in Bodybereich vergraden ist.

Dieses Gebiet des anderen Leitungstyps, das den gleichen Leitungstyp wie der Bodybereich hat, ist am pn-Übergang zwischen dem Halbleiterkörper und dem Bodybereich vorgesehen und hat einen steileren Dotierstoffgradienten als der Bodybereich.

Bei dem erfindungsgemäßen avalanchefesten Trench-MOS-Transistor mit tiefem Trench und Oxidstufe im Trench ist also ein zusätzliches Gebiet vorgesehen, das bevorzugt durch Ionenimplantation eingebracht ist d.h. ein Ionenimplantationsgebiet ist, und das elektrische Feld am pn-Übergang zwischen Bodybereich und Halbleiterkörper erhöht, so daß der Durchbruch an diesem pn-Übergang bei einer niedrigeren Source-Drain-Spannung des MOS-Transistors erfolgt als der Durchbruch an der Oxidstufe. Bei dem Halbleiterkörper handelt es sich hierbei in bevorzugter Weise um eine auf einem Halbleitersubstrat aus Silizium aufgebrachte epitaktische Schicht aus Silizium. Dieses zusätzliche Gebiet ist im Bodybereich vergraben und erhöht dort zwischen Trenches die Dotierungskonzentration.

Der Trench selbst kann dabei grundsätzlich bereits in der epitaktischen Schicht des Halbleiterkörpers enden oder bis in das Halbleitersubstrat hinein reichen.

In vorteilhafter Weise ist es weiterhin möglich, die Stufe zwischen der Isolierschicht mit größerer Schichtdicke und der Isolierschicht mit kleinerer Schichtdicke abzuschrägen, wodurch das elektrische Feld an der Stufe vermindert wird.

Wesentlich an der vorliegenden Erfindung ist also die Einführung eines zusätzlichen Gebietes des anderen Leitungstyps im Bodybereich am pn-übergang mit dem Halbleiterkörper. Dieses Gebiet muß nicht an den gesamten pn-übergang reichen und braucht auch nicht von der Oberfläche her ausdiffundiert zu werden. Durch dieses zusätzliche Gebiet, das insbesondere durch Implantation eingebracht ist, wird die Durchbruchsspannung nicht wie in üblicher Weise (vgl. beispielsweise EP-A-0 746 030 oder US-A-5 072 266) durch einen kleineren Abstand zwischen Zusatzdotierung und Substrat im Vergleich zum Abstand zwischen Trenchboden und Substrat, sondern durch eine höhere Dotierungskonzentration und durch Einbeziehung der das elektrische Feld modellierenden Wirkung der tiefen Trenches festgehalten. Als Vorteil der Erfindung ist auch zu erwähnen, daß das zusätzliche Gebiet mit der höheren Dotierung nicht bis unter die Trenches zu reichen braucht.

Das zusätzliche Gebiet, das den Bodybereich verstärkt und in bevorzugter Weise durch Ionenimplantation eingebracht ist, kann mittels Phototechnik zwischen zwei Trenches vorgesehen und ausgeheilt werden, so daß die Dotierung im eigentlichen Kanalbereich nicht verändert wird. Eine praktische Ausführung kann beispielsweise mittels quadratischen Zellen oder in Streifenform erfolgen.

Weiterhin ist es auch möglich, das zusätzliche und den Bodybereich verstärkende Gebiet in Streifen senkrecht zu den Trenches oder sonstigen beliebigen geometrischen Formen durch beispielsweise Implantation einzubringen und auszuheilen, so daß die Dotierung im Kanalbereich erhöht wird und dieser Teil des MOS-Transistors nicht mehr zum Kanalstrom beiträgt. Nachfolgend wird die Erfindung anhand der Zeichnungen näher erläutert. Es zeigen:
- Fig. 1: ein Ausführungsbeispiel des erfindungsgemäßen Trench-MOS-Transistors in Perspektive,
- Fig. 2: eine Schnittdarstellung einer halben Transistor- zelle ohne Body-Verstärkungsimplantation,
- Fig. 3: eine Schnittdarstellung einer halben Transistor- zelle mit Body-Verstärkungsimplantation zwischen jeweiligen Trenches,
- Fig. 4: eine Draufsicht auf eine Streifenanordnung von Trenches und Body-Verstärkungsimplantationen,
- Fig. 5: eine Draufsicht auf eine Transistor-Zellenanord- nung,
- Fig. 6: eine Draufsicht auf Body-Verstärkungsimplanta- tionen in senkrecht zu Trenchstreifen verlaufen- den Streifen,
- Fig. 7: den Verlauf der Dotierungskonzentration in Abhän- gigkeit von der Tiefe bei einer Anordnung nach Fig. 6 und
- Fig. 8: den Verlauf der Dotierungskonzentration in Abhän- gigkeit von der Tiefe bei einer Anordnung nach Fig. 4.

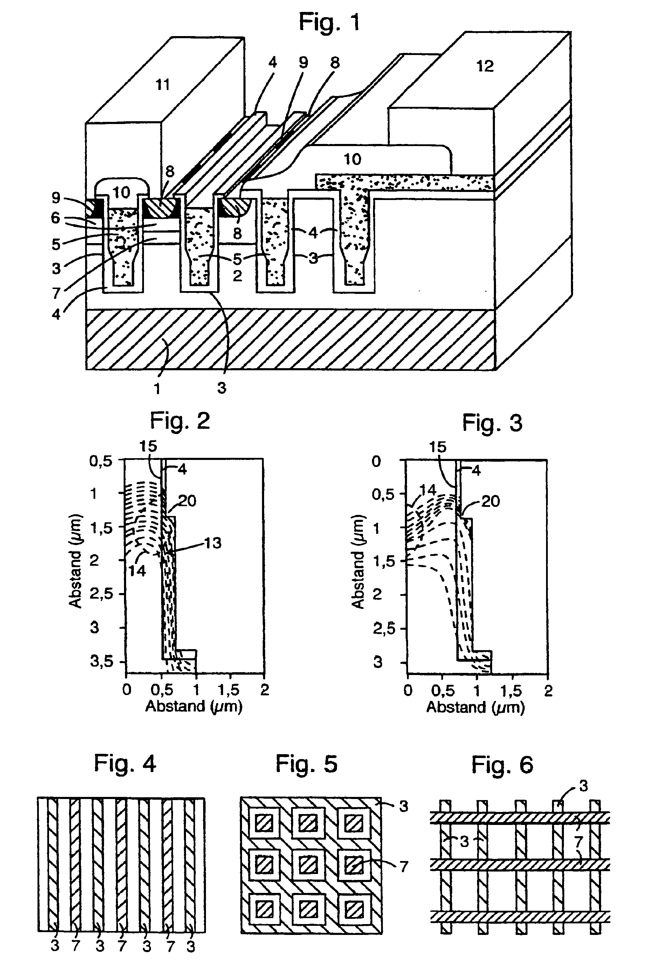

Fig. 1 zeigt einen erfindungsgemäßen Trench-MOS-Transistor in Perspektive. Dieser Transistor weist ein p⁺-leitendes Silizium-Halbleitersubstrat auf, auf welchem eine p-leitende epitaktische Schicht 2 aus Silizium aufgebracht ist. In dieser p-leitenden epitaktischen Schicht 2 sind mehrere Trenches bzw. Gräben 3 vorgesehen, bei denen die Wände und Böden mit einer Isolierschicht 4 aus Siliziumdioxid belegt sind. Anstelle von Siliziumdioxid können auch andere Materialien, wie beispielsweise Siliziumnitrid oder Filme aus Siliziumdioxid und Siliziumnitrid vorgesehen werden. Dabei besteht in dieser Isolierschicht 4 eine Stufe 20: die Isolierschicht ist nämlich im unteren Teil der Gräben 3 dicker als in deren oberen Bereich. Diese Stufe 20 ist dadurch bedingt, daß zur Reduzierung des Widerstandes der Driftstrecke, des sogenannten "Epiwiderstandes", die Trenches 3 tief gestaltet werden. Für diese tiefe Gestaltung der Trenches 3 muß in deren unterem Bereich aber eine dicke Isolierschicht, also ein dickeres Siliziumdioxid, vorgesehen werden.

Die mit der Isolierschicht 4 ausgelegten Trenches sind mit polykristallinem Silizium 5 gefüllt, das gegebenenfalls dotiert sein kann. Im oberen Bereich der epitaktischen Schicht 2 ist ein n-leitender Bodybereich 6 vorgesehen, der mit Bodykontakten 8 ausgestattet ist und in dem sich Sourcezonen 9 erstrecken.

Außerdem ist in Fig. 1 eine Isolierschicht 10 aus beispielsweise Borphosphorsilikatglas gezeigt, die insbesondere eine Gateelektrode 12 von einer Sourceelektrode 11 trennt, welche den Bodykontakt 8 und die Sourcezone 9 kontaktiert. Die Elektroden 11, 12 können beispielsweise aus Aluminium bestehen.

Bei diesem MOS-Transistor fließt der Strom durch den eine Kanalzone bildenden Bodybereich 6 von der Sourcezone 9 zu der epitaktischen Schicht 2 bzw. zu dem p⁺-leitenden Substrat 1, welche zusammen eine Drainzone darstellen. Der Stromfluß wird dabei durch die an die Gateelektrode 12 und damit an das polykristalline Silizium 5 gelegte Spannung gesteuert.

Bei einem MOS-Transistor, wie dieser oben erläutert ist, treten an der Stufe 20, also dem Übergang von dem dünnen Oxid zu dem dicken Oxid der Isolierschicht 4 mit einem Oxidrand 15 im Trench 3 elektrische Feldspitzen im Silizium auf. Dies ist aus Fig. 2 zu ersehen, in welcher elektrische Äquipotentiallinien 13 zusammen mit einem Bereich 14 gezeigt sind, in welchem bevorzugt Avalanche-Durchbrüche zu verzeichnen sind. Bei zu kleinem Abstand zwischen den benachbarten Trenches 3 sind nämlich diese Feldspitzen höher als das elektrische Feld in der Zellmitte am pn-Übergang zwischen dem Bodybereich 6 und der epitaktischen Schicht 2, so daß eine Lawinenmultiplikation und eine Injektion von heißen Ladungsträgern in die Isolierschicht 4 auftreten, wodurch die Isolierschicht 4 geschädigt wird und sogar eine Zerstörung des Transistors resultieren kann.

Dieses Problem wird durch die Erfindung dadurch gelöst, daß ein zusätzliches Gebiet 7, das n-leitend und dabei höher dotiert als der Bodybereich 6 ist, insbesondere durch Ionenimplantation vorgesehen wird. Dadurch wird das elektrische Feld am pn-Übergang zwischen dem Bodybereich 6 und der epitaktischen Schicht 2 erhöht, so daß der Durchbruch bevorzugt am pn-Übergang bei einer niedrigeren Source-Drain-Spannung als der Durchbruch an der Stufe 20 erfolgt. Es ist dabei zweckmäßig, wenn der Übergang zwischen dem dünneren und dickeren Teil der Isolierschicht 4 abgeschrägt wird. Das heißt, die Stufe 20 wird zweckmäßigerweise schräg gestaltet, wie dies auch aus der Fig. 1 zu ersehen ist.

Das Gebiet 7 wird zweckmäßigerweise durch Ionenimplantation eingebracht. Selbstverständlich können gegebenenfalls aber auch andere Verfahren angewandt werden, um dieses Gebiet 7 zu erzeugen. Vorzugsweise haben die Gebiete 7 einen steileren Dotierstoffgradienten als der Bodybereich 6.

Fig. 3 zeigt den Verlauf des elektrischen Feldes mit den Äquipotentiallinien 13 ähnlich zu Fig. 2, wobei hier aber ein Durchbruch nicht mehr an der Stufe 20 erfolgt. Vielmehr ist der Bereich 14, in welchem ein Durchbruch bevorzugt zu beobachten ist, in das Innere des Bodybereiches verlagert, in welchem bevorzugt der Strom im Avalanchefall fließt. Mit anderen Worten, der Durchbruch erfolgt nicht mehr im Bereich der Wand des Trenches 3.

Die Fig. 4 bis 6 zeigen verschiedene Ausführungsbeispiele für die Anordnung der Trenches 3 zu den zusätzlichen Gebieten 7:

Die Gebiete 7 zur Bodyverstärkung können - mittels Phototechnik justiert - jeweils zwischen zwei Trenches 3 implantiert und ausgeheilt werden (vgl. Fig. 4), wodurch die Dotierung im Kanalbereich nicht verändert wird. Eine andere mögliche Gestaltung ist in Fig. 5 mit quadratischen Zellen der Gebiete 7 gezeigt, welche zwischen sich senkrecht kreuzenden Trenches angeordnet sind.

Eine weitere bevorzugte Ausführungsform ist in Fig. 6 dargestellt, in welcher die Gebiete 7 senkrecht zu den Trenches 3 verlaufen. Dabei sind die Gebiete implantiert und derart ausgeheilt, daß die Dotierung im Kanalbereich erhöht wird und dieser Teil des MOS-Transistors nicht mehr zum Kanalstrom beiträgt.

Der erfindungsgemäße avalanchefeste MOS-Transistor hat also das zusätzliche Gebiet 7, das bevorzugt durch Ionenimplantation eingebracht ist und nicht an den gesamten pn-übergang zwischen "Bodydotierung" und Halbleiterkörper reichen muß. Auch braucht dieses Gebiet nicht von der Oberfläche her ausdiffundiert zu werden. Es klemmt die Durchbruchsspannung durch seine höhere Dotierstoffkonzentration und durch Einbeziehung der feldmodellierenden Wirkung der tiefen Trenches mit der Stufe 20 fest.

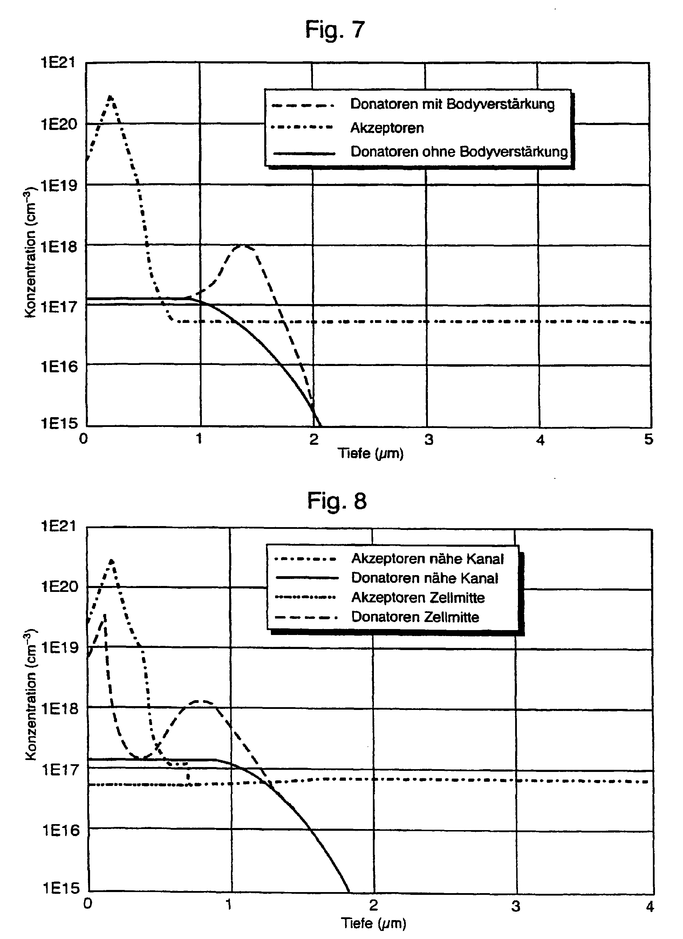

Der Verlauf der Dotierungen ist in der Fig. 7 für eine Anordnung nach Fig. 6 gezeigt. Es ist hier deutlich zu sehen, daß bei der Erfindung ("Donatoren mit Bodyverstärkung") die Dotierungskonzentration im Bereich von etwa 10¹⁷ bis über 10¹⁹ Ladungsträger cm⁻³ in dem Gebiet 7 beträgt, was deutlich oberhalb der üblichen Dotierung des Bodybereiches ("Donatoren ohne Bodyverstärkung") liegt. Die durch Simulation erhaltenen Ergebnisse der Fig. 7 sind in den Gebieten 7 nahe an deren Schnittstelle mit den Trenches 3 gezeigt.

Fig. 8 zeigt eine ähnliche Darstellung wie Fig. 7 für eine Anordnung nach Fig. 4, wobei "Nähe Kanal" eine Stelle in der Nähe der Trenche bedeutet, während unter "Zellmitte" eine Stelle in der Mitte des streifenförmigen Gebietes 7 zu verstehen ist. Aus Fig. 8 ist zu ersehen, daß die Dotierungskonzentration in den Gebieten 7 hier etwa 10¹⁷ bis 10¹⁹ Ladungsträger cm⁻³ beträgt.

Die obigen Dotierungskonzentrationen sind lediglich ungefähre Werte für die Dotierung in den n-leitenden Gebieten 7. Selbstverständlich können auch andere Werte, also beispielsweise höher als 10¹⁹ Ladungsträger cm³ angewandt werden.

Auch ist es möglich, die angegebenen Polaritäten zu vertauschen, so daß dann das Gebiet 7 beispielsweise mit Bor p-dotiert ist.

Schließlich reichen in den obigen Ausführungsbeispielen die Trenches 3 bis in die Nähe des unteren Endes der p-leitenden epitaktischen Schicht 2. Es ist aber auch möglich, daß die Trenches 3 bis in das p⁺-leitende Substrat 1 hinein vorgetrieben sind.

## Patentansprüche

1. Trench-MOS-Transistor mit einem Halbleiterkörper (1, 2) des einen Leitungstyps, in welchem ein mit einer Gateelektrode (5, 12) versehener Graben (3) vorgesehen ist, der in einer Seitenfläche an seinem oberen Ende wenigstens eine Sourcezone (9) des einen Leitungstyps aufweist und mit seinem unteren Ende in den wenigstens eine Drainzone des einen Leitungstyps bildenden Halbleiterkörper (1, 2) hineinreicht, wobei zwischen Sourcezone (9) und Drainzone (1, 2) ein Bodybereich (6) des anderen Leitungstyps und ein höher als der Bodybereich (6) dotiertes Gebiet (7) des anderen Leitungstyps vorgesehen sind und die Gateelektrode (5, 12) von Sourcezone (9), Bodybereich (6) und Drainzone durch eine Isolierschicht (4) getrennt ist, die eine Stufe (20) aufweist, so daß die Isolierschicht (4) zum unteren Ende des Grabens (3) hin eine größere Schichtdicke als an dessen oberem Ende hat,
**dadurch gekennzeichnet, dass**
der Bodybereich (6) zur Drainzone hin zwischen dem Graben und einem benachbarten, ebenso mit einer Gateelektrode versehenen Graben des Trench-MOS-Transistors mit dem Gebiet (7) des anderen Leitungstyps verstärkt ist, wobei dieses Gebiet (7) im Bodybereich (6) vergraben ist.

2. Trench-MOS-Transistor nach Anspruch 1,
**dadurch gekennzeichnet, daß**
das Gebiet (7) des anderen Leitungstyps einen steileren Dotierstoffgradienten als der Bodybereich (6) hat.

3. Trench-MOS-Transistor nach Anspruch 1 oder 2,
**dadurch gekennzeichnet, daß**
die Stufe (20) der Isolierschicht (4) abgeschrägt ist.

4. Trench-MOS-Transistor nach einem der Ansprüche 1 bis 3,
**dadurch gekennzeichnet, daß**
das Gebiet (7) des anderen Leitungstyps ein Ionenimplantationsgebiet ist.

5. Trench-MOS-Transistor nach einem der Ansprüche 1 bis 4,
**dadurch gekennzeichnet, daß**
das Gebiet (7) des anderen Leitungstyps streifenförmig gestaltet ist.

6. Trench-MOS-Transistor nach Anspruch 5,
**dadurch gekennzeichnet, daß**
das Gebiet (7) des anderen Leitungstyps im Abstand zwischen Gräben (3) parallel zu diesen angeordnet ist.

7. Trench-MOS-Transistor nach Anspruch 5,
**dadurch gekennzeichnet, daß**
das Gebiet (7) des anderen Leitungstyps senkrecht zu den Gräben (3) verläuft.

8. Trench-MOS-Transistor nach Anspruch 6,
**dadurch gekennzeichnet, daß**
die Ladungsträgerkonzentration in dem Gebiet (7) des anderen Leitungstyps 10¹⁷ bis 10¹⁹ Ladungsträger/cm³ beträgt.

9. Trench-MOS-Transistor nach einem der Ansprüche 1 bis 8,
**dadurch gekennzeichnet, daß**
der Halbleiterkörper (1, 2) eine auf einem Halbleitersubstrat (1) vorgesehene epitaktische Schicht (2) ist, und daß der Graben (3) in die epitaktische Schicht (2) eingebracht ist.

10. Trench-MOS-Transistor nach Anspruch 9,
**dadurch gekennzeichnet, daß**
der Graben (3) in der Nähe des Überganges zwischen der epitaktischen Schicht (2) und dem Substrat (1) endet.

11. Trench-MOS-Transistor nach einem der Ansprüche 1 bis 10,
**dadurch gekennzeichnet, daß**
der eine Leitungstyp der p-Leitungstyp ist.

## Claims

1. Trench MOS transistor having a semiconductor body (1, 2) of the first conduction type, in which a trench (3) provided with a gate electrode (5, 12) is provided, which has at least one source zone (9) of the first conduction type in a side area at its upper end and reaches with its lower end into the semiconductor body (1, 2) forming at least one drain zone of the first conduction type, a body region (6) of the second conduction type and a region (7) of the second conduction type which is doped more highly than the body region (6) being provided between source zone (9) and drain zone (1, 2) and the gate electrode (5, 12) being isolated from source zone (9), body region (6) and drain zone by an insulating layer (4) which has a step (20), so that the insulating layer (4) has a larger layer thickness toward the lower end of the trench (3) than at the upper end thereof,
**characterized in that**
the body region (6) is reinforced with the region (7) of the second conduction type toward the drain zone between the trench and an adjacent trench, likewise provided with a gate electrode, of the trench MOS transistor, said region (7) being buried in the body region (6).

2. Trench MOS transistor according to Claim 1,
**characterized in that**
the region (7) of the second conduction type has a steeper dopant gradient than the body region (6).

3. Trench MOS transistor according to Claim 1 or 2,
**characterized in that**
the step (20) of the insulating layer (4) is beveled.

4. Trench MOS transistor according to one of Claims 1 to 3,
**characterized in that**
the region (7) of the second conduction type is an ion implantation region.

5. Trench MOS transistor according to one of Claims 1 to 4,
**characterized in that**
the region (7) of the second conduction type is of strip-type configuration.

6. Trench MOS transistor according to Claim 5,
**characterized in that**
the region (7) of the second conduction type is arranged at a distance between trenches (3) parallel to the latter.

7. Trench MOS transistor according to Claim 5,
**characterized in that**
the region (7) of the second conduction type runs perpendicularly to the trenches (3).

8. Trench MOS transistor according to Claim 6,
**characterized in that**
the charge carrier concentration in the region (7) of the second conduction type is 10¹⁷ to 10¹⁹ charge carriers/cm³_{.}

9. Trench MOS transistor according to one of Claims 1 to 8,
**characterized in that**
the semiconductor body (1, 2) is an epitaxial layer (2) provided on a semiconductor substrate (1), and **in that** the trench (3) is introduced into the epitaxial layer (2).

10. Trench MOS transistor according to Claim 9,
**characterized in that**
the trench (3) ends in the vicinity of the junction between the epitaxial layer (2) and the substrate (1).

11. Trench MOS transistor according to one of Claims 1 to 10,
**characterized in that**
the first conduction type is the p conduction type.

## Revendications

1. Transistor MOS à sillon, ayant un corps (1, 2) semiconducteur d'un type de conductivité, dans lequel est prévu un sillon (3) qui est muni d'une électrode (5, 12) de grille, qui a au moins une zone de source du un type de conductivité dans une surface latérale à son extrémité supérieure et qui pénètre par son extrémité inférieure dans le corps (1, 2) semiconducteur formant au moins une zone de drain du un type de conductivité, dans lequel il est prévu, entre la zone (9) de source et la zone (1, 2) de drain, une région (6) de corps de l'autre type de conductivité et un domaine de l'autre type de conductivité plus dopé que la région (6) de corps et l'électrode (5, 12) de grille est isolée de la zone (9) de source, de la région (6) de corps et de la zone de drain par une couche (4) isolante qui a un gradient (20) de sorte que la couche (4) isolante a, vers l'extrémité inférieure du sillon (3), une épaisseur de couche plus grande qu'à son extrémité supérieure
**caractérisé en ce que**
la région (6) de corps allant vers la zone de drain est renforcée entre le sillon et un sillon voisin, également muni d'une électrode de grille, du transistor MOS à sillon par le domaine (7) de l'autre type de conductivité, ce domaine (7) étant enfoui dans la région (6) de corps.

2. Transistor MOS à sillon, suivant la revendication 1,
**caractérisé en ce que** le domaine (7) de l'autre type de conductivité a un gradient de substance de dopage plus abrupte que la région (6) de corps.

3. Transistor MOS à sillon, suivant la revendication 1 ou 2,
**caractérisé en ce que** le gradin (20) de la couche (4) isolante est biseauté.

4. Transistor MOS à sillon, suivant l'une des revendications 1 à 3,
**caractérisé en ce que** le domaine (7) de l'autre type de conductivité est un domaine à implantation d'ions.

5. Transistor MOS à sillon, suivant l'une des revendications 1 à 4,
**caractérisé en ce que** le domaine (7) de l'autre type de conductivité est en forme de bande.

6. Transistor MOS à sillon, suivant la revendication 5,
**caractérisé en ce que** le domaine (7) de l'autre type de conductivité est disposé dans l'intervalle entre des sillons (3) parallèlement à ceux-ci.

7. Transistor MOS à sillon, suivant la revendication 5,
**caractérisé en ce que** le domaine (7) de l'autre type de conductivité s'étend perpendiculairement aux sillons (3).

8. Transistor MOS à sillon, suivant la revendication 6,
**caractérisé en ce que** la concentration de porteurs de charge dans le domaine (7) de l'autre type de conductivité va de 10¹⁷ à 10¹⁹ porteurs de charge/cm³.

9. Transistor MOS à sillon, suivant l'une des revendications 1 à 8,
**caractérisé en ce que** le corps (1, 2) semiconducteur est une couche (2) épitaxiale munie d'un substrat (1) semiconducteur et **en ce que** le sillon (3) est ménagé dans la couche (2) épitaxiale.

10. Transistor MOS à sillon, suivant la revendication 9,
**caractérisé en ce que** le sillon (3) se termine à proximité de la transition entre la couche (2) épitaxiale et le substrat (1).

11. Transistor MOS à sillon, suivant l'une des revendications 1 à 10,
**caractérisé en ce que** le un type de conductivité est le type de conductivité p.
